# EUROPEAN PATENT APPLICATION

(11) **EP 1 196 020 A2**
(43) Date of publication of application: **10.04.2002**
(21) Application number: 01308522.0
(22) Date of filing: 05.10.2001
(51) Int. Cl.: H05K 13/00

(54) **Method of detecting position of printed-wiring board**

(30) Priority: 05.10.2000 JP 2000305926
(71) Applicant: Fuji Machine Mfg. Co., Ltd., Chiryu-shi, Aichi-ken (JP)
(72) Inventor: Hattori, Tomohiko, c/o Fuji Machine Mfg Co Ltd, Chiryu-shi, Aichi-ken (JP)
(74) Representative: Moir, Michael Christopher

(57) **Abstract**

A method of detecting a position of a printed-wiring board (20) as held by a board supporting device (132; 400; 500) in a printed-wiring-board working system arranged to effect a working operation on a front surface (272) of the printed-wiring board, wherein at least one image-taking device (140; 404; 522) is operated to take an image of each of at last one indicium provided on a back surface (270) of the board as held by the board supporting device (132; 400; 500), and the position of the board is detected on the basis of a position of the image of each indicium in an imaging area of the image-taking device. Also disclosed are method and system for effecting a working operation on the board, using the detected position of the board.

## Description

### BACKGROUND OF THE INVENTION

### Field of the Invention

The present invention relates to detection of position and positioning error of a printed-wiring board, in a printed-wiring-board working system arranged to effect, on the printed-wiring board, a desired working operation such as an operation to apply an adhesive agent or a creamy solder (soldering paste) to the printed-wiring board, an operation to mount electric components (including electronic components) on the printed-wiring board, or an operation to inspect a printed-circuit board, namely, the printed-wiring board on which the electric components have been mounted.

### Discussion of Related Art

Such a printed-wiring-board working system is commonly provided with a printed-wiring-board supporting device for supporting or holding a printed-wiring board, a working head adapted to perform a desired working operating on the surface of the printed-wiring board held by the printed-wiring-board supporting device, a relative-movement device adapted to move the printed-wiring board and the working head relative to each other in a plane parallel to the surface of the board, and a control device arranged to control the working head and the relative-movement device. In operation, the working head performs the predetermined working operation at a predetermined position or positions on the printed-wiring board held by the supporting device, while the relative-movement device and the working head are controlled by the control device according to a predetermined control program. In the presence of any positioning error of the printed-wiring board as held by the printed-wiring-board supporting device, the working operation cannot be effected exactly at the predetermined position or positions on the board.

To avoid the problem indicated above, the known printed-wiring-board working system is arranged to detect the position or a positioning error of the printed-wiring board as held by the printed-wiring-board supporting device, and compensate the relative movement of the relative-movement device and the working head, more precisely, the relative position between the relative-movement device and the working head, or the amount of relative movement of the relative-movement device and the working head, on the basis of the detected position or positioning error of the printed-wiring board.

However, the detection of the position or positioning error of the printed-wiring board as held by the printed-wiring-board supporting device is undesirably one of factors that lower the working efficiency of the printed-wiring-board working system. The known system is arranged to detect the position or positioning error of the printed-wiring board, by using an image-taking device which is adapted to take an image of a predetermined indicium or icon such as a fiducial mark provided on the top surface of the printed-wiring board, or a selected portion of a printed wiring pattern formed on the board. To this end, the image-taking device is required to be disposed on the top or upper side of the printed-wiring board on which the working head is disposed. This arrangement requires the working operation to be performed so as to prevent an interference of the working head with the image-taking device, and inevitably suffers from a decrease in the working efficiency of the system. For instance, the working head and the image-taking device are mounted on respective movable members which are moved by respective moving or positioning devices. In this instance, the cost of manufacture of the printed-working-board working system is undesirably increased. Further, the working head cannot be moved, or a permissible range of movement of the working head is limited, while the image-taking device is in operation, so that the working efficiency of the system is lowered. Alternatively, the image-taking device is mounted on the movable member on which the working head is mounted. This arrangement permits movements of the working head and the image-taking device, while maintaining a predetermined relative position therebetween, so that the working head and the image-taking device do not interfere with each other. On the other hand, however, the same arrangement causes unnecessary movements of the image-taking device when the working head is moved during its working operation. This causes an increase in the inertia mass of an assembly including the working head and the Image-taking device, and therefore limits the permissible maximum values of acceleration and deceleration of the working head, inevitably leading to a decrease in the working efficiency of the system.

### SUMMARY OF THE INVENTION

The present invention was made in view of the background art discussed above. It is therefore an object of the present invention to detect the position or positioning error of a printed-wiring board while avoiding at least one of an increase in the cost of manufacture and a decrease in the working efficiency of a printed-wiring-board working device.

In a first aspect, the present invention provides a method of detecting a position of a printed-wiring board as held by a board supporting device in a system arranged to operate on a front surface of said printed-wiring board, said method comprising the steps of:
operating at least one image-taking device to take an image of each of at least one indicium provided on a back surface of said printed-wiring board as held by said board supporting device; and
detecting the position of said printed-wiring board on the basis of a position of said image of each of said at least one indicium in an imaging area of the corresponding one of said at least one image-taking device.

A preferred embodiment provides a method of detecting a position of a printed-wiring board as held by a board supporting device in a printed-wiring-board working system arranged to effect a working operation on a front surface of said printed-wiring board, the method being characterized by comprising the steps of: operating at least one image-taking device to take an image of each of at least one indicium provided on a back surface of the printed-wiring board as held by the board supporting device; and detecting the position of the printed-wiring board on the basis of a position of the image of each of the at least one indicium in an imaging area of the corresponding one of the at least one image-taking device.

Each image-taking device is required to be located at a position at which the image of the indicium can be taken. In addition, detecting the position of the printed-wiring board requires accurate detection of the position of the image-taking device per se. Where the indicium is a fiducial mark located at a predetermined position on the back surface of the printed-wiring board, the image-taking device may be disposed at a predetermined position. However, the fiducial marks provided on printed-wiring boards having different sizes are generally located at respective different positions. In this case, each image-taking device is required to be located at a selected one of different positions, depending upon the position of the fiducial mark on the specific printed-wiring board. Where the printed-wiring board has a high degree of rigidity, the position of the printed-wiring board can be detected by taking images of two fiducial marks which are spaced apart from each other on the printed-wiring board. Where the rigidity of the printed-wiring board is comparatively low, it may be necessary to take images of three or more fiducial marks located at the respective different positions on the board. In those cases, it may be better to move a single image-taking device to a plurality of positions for taking the images of the plurality of fiducial marks at the different positions. In any case, each image-taking device is required to be accurately located at the nominal position or positions, or the positioning error of the image-taking device with respect to the nominal positions must be accurately determined.

The image-taking device per se may be oriented so as to be opposed to the indicium provided on the printed-wiring board. However, the image-taking device may be provided with suitable light-deflecting means or waveguide device including a prism, a reflecting mirror or other optical elements. In this case, the light-deflecting means is opposed to the indicium.

According to the method according to the above aspect of this invention, the image of each of the at least one indicium provided on the back surface of the printed-wiring board as held by the board supporting device is taken by the at least one image-taking device, and the position of the printed-wiring board is detected or determined on the basis of the position of the image of each indicium in the imaging area of each image-taking device. The position of the image of each indicium provided on the back surface of the printed-wiring board represents the position of the board on which the working operation is to be performed, that is, the position of a printed wiring pattern formed on the front surface of the board, or the positioning error of the printed wiring pattern, as long as the at least one indicium is accurately located on the board, at a predetermined position relative to the position of the printed wiring pattern.

The present method permits the detection of the position of the printed-wiring board by the at least one image-taking device, during preparation for the working operation on the board, or simultaneously with the working operation, without lowering the efficiency of the working operation.

In one embodiment, the at least one indicium consists of at least one fiducial mark positioned on said back surface of the printed-wiring board, in a predetermined positional relationship with a printed wiring pattern formed on the front surface of the board.

In another embodiment, the at least one indicium consists of at least one predetermined portion of a printed wiring pattern which is formed on the back surface of the printed-wiring board, in a predetermined positional relationship with a printed wiring pattern formed on the front surface of the board.

Where at least one predetermined portion of the printed wiring pattern formed on the back surface of the printed-wiring board is used as the at least one indicium, the present method can be practiced without having to provide the board with an indicium or indicia for exclusive use for the purpose of detecting the position of the board.

Preferably, the printed-wiring board has a plurality of indicia.

Preferably, the at least one image-taking device consists of a plurality of image-taking devices, the method further comprising locating the plurality of image-taking devices at respective positions at which the images of the plurality of indicia can be respectively taken by the plurality of image-taking devices.

Preferably, the image-taking devices are located at the respective positions before the printed-wiring board is held by the board supporting device.

Where the printed-wiring board has a high degree of rigidity, or is supported by backup pins with suction cups such that the printed-wiring board has a high degree of flatness or straightness, the position of the board can be determined on the basis of the images of the two indicia which are spaced apart from each other. In those cases, the two image-taking devices are disposed at respective two positions at which the two indicia can be imaged. Where the amount of deflection or flexure of the board is not negligible, it is desirable to take images of three or more indicia, which are imaged by respective three image-taking devices.

Preferably, the plurality of image-taking devices are manually located at the respective positions.

Where the image-taking devices are manually located at the respective positions, the printed-wiring-board working system can be comparatively simplified in construction and is accordingly available at a comparatively low cost. However, the image-taking devices may be automatically located at the respective positions, by a suitable positioning device. When the image-taking devices have been located at the respective positions, it is preferable to detect the actual positions of the image-taking devices.

A second aspect of the present invention provides a method of performing a working operation on a front surface of a printed-board in a system which comprises a board supporting device operable to hold the printed-wiring board, a working head operable to effect the working operation on the front surface of the printed-wiring board, and a relative-movement device operable to move the printed-wiring board and the working head relative to each other in a plane substantially parallel to the front surface, the method comprising the steps of:
operating at least one image-taking device to take an image of each of at least one indicium provided on a back surface of the printed-wiring board as held by the board supporting device;
detecting a positioning error of the printed-wiring board as held by the board supporting device, on the basis of a position of the image of the each indicium in an imaging area of the corresponding one of the at least one image-taking device; and
compensating a relative movement between the board supporting device and the working head by the relative-movement device, on the basis of the positioning error detected.

A third aspect of the present invention provides a system for effecting a working operation on a front surface of a printed-wiring board, characterized by comprising:
a board supporting device operable to hold the printed-wiring board:
   a working head operable to effect the working operation on the front surface of the printed-wiring board;
   a relative-movement device operable to move the printed-wiring board and the working head relative to each other in a plane parallel to the front surface;
   at least one image-taking device operable to take an image of each of at least one indicium provided on a back surface of the printed-wiring board as held by the board supporting device; and
   a control device operable to control the working head, the relative-movement device and the at least one image-taking device, the control device detecting a positioning error of the printed-wiring board as held by the board supporting device, on the basis of a position of the image of the each indicium in an imaging area of the corresponding one of the at least one image-taking device,
   and wherein the control device is operable compensate a relative movement between the board supporting device and the working head by the relative-movement device, so as to reduce the positioning error detected,

Preferably the system comprises an imaging-device holding device which is disposed so as to be opposed to the back surface of the printed-wiring board and which holds the at least one image-taking device.

Preferably the imaging-device holding device includes a mounting device arranged to hold the at least one image-taking device such that a position of each of the at least one image-taking device is adjustable.

Preferably the imaging-device holding device includes s support table having a flat supporting surface, and the mounting device includes a mounting member to which each of the at least one image-taking device is fixed, one of the support table and the mounting member including a magnet portion, while the other of the support table and the mounting member including a ferromagnetic portion formed of a ferromagnetic material.

Preferably the imaging-device holding device has a flat supporting surface and a first and a second group of T-slots, the first group of T-slots consisting of a plurality of parallel T-slots, and the second group of T-slots consisting of a plurality of parallel T-slots perpendicular to the T-slots of the first group, and wherein the mounting device includes a plurality of T-blocks slidably received in the T-slots, and fastening members which cooperate with the T-blocks to hold the at least one image-taking device.

In one embodiment, the system comprises an imaging-device holding device which is movable in two mutually perpendicular directions and which holds the at least one image-taking device.

Where the amount of deflection or flexure of the printed-wiring board is not negligible, it is desirable to take the images of three or more indicia, as described above. In this case, the three or more image-taking devices may be provided. However, it is desirable that one image-taking device or two image-taking devices can be movable to a desired position in the XY plane. That is, it is desirable to provide the imaging-device holding device which holds the image-taking device or devices. This imaging-device holding device is movable to move each image-taking device in the plane parallel to the back surface of the printed-wiring board. However, the imaging-device holding device need not be adapted to move each image-taking device over an area corresponding to the entire surface area of the printed-wiring board, but may be adapted to move at least one image-taking device over an area corresponding to at least a portion of the surface area of the board.

Preferably the imaging-device holding device includes two movable members, and an X-axis drive device and a Y-axis drive device which include respective drive sources operable to move the two movable members in an X-axis direction and a Y-axis direction, respectively, and a controller for electrically controlling the drive sources.

As described above it is desirable that one image-taking device or two image-taking devices can be movable to a desired position in the XY plane. Although the image-taking device can be moved manually by rotating feedscrews operatively connected to the imaging-device holding device, the working efficiency of the system can be improved where the imaging-device holding device includes two movable members driven by the respective power drive sources electrically controlled by the controller.

Preferably, the system comprises a moving device operable to move the imaging-device holding device toward and away from the back surface of the printed-wiring board held by the board supporting device.

The moving device operable to move the imaging-device holding device toward and away from the printed-wiring board permits the at least one image-taking device to function as a support structure for supporting the printed-wiring board, as described below, or alternatively enable the at least one image-taking device to be normally held apart from the back surface of the board and to be located close to the back surface when the at least one image-taking device is operated. Further, the moving device permits adjustment of the position of each image-taking device relative to the back surface of the printed-wiring board, for focusing each image-taking device on the back surface.

Preferably each of the at least one image-taking device includes a contact portion for contact with the back surface of the printed-wiring board, to support the printed-wiring board on the back surface.

In the printed-wiring-board working device according to the above, each image-taking device functions as a part of the board supporting device, for improving the stability of holding of the board. Further, the contact portion of each image-taking device also functions to optically isolate the interior of the image-taking device from an external optical noise, thereby permitting the image-taking device to take a high-quality image of the indicium. Each image-taking device may be arranged to hold the printed-wiring board by suction under a negative pressure, rather than to simply contact the back surface of the board. In this case, the flatness or straightness of the board can be improved. To hold the board by suction, a covering member may be provided to enclose the image-taking device, so that a negative pressure is introduced into the interior of the covering member to hold the board by suction under the negative pressure. The contact portion of the image-taking device is preferably arranged to contact a portion of the back surface of the board in which a printed wiring pattern is not formed.

Preferably the contact portion has a contact surface shaped to enclose one of the at least one indicium such that the contact surface is located outwardly of the one indicium.

Preferably the at least one image-taking device consists of a plurality of image-taking devices.

Preferably the working head is an electric-component mounting head operable to mount an electric component at a predetermined position on the front surface of the printed-wiring board.

Any features relating to system aspects of the present invention are equally applicable to method aspects, or vice versa.

### BRIEF DESCRIPTION OF THE DRAWINGS

The above and other objects, features, advantages and technical and industrial significance of the present invention will be better understood by reading the following detailed description of presently preferred embodiments of the invention, when considered in connection with the accompanying drawings, in which:
Fig. 1 is a plan view schematically showing an electric-component mounting system constructed according to one embodiment of this invention;
Fig. 2 is a fragmentary side elevational view (partly in cross section) of the electronic-component mounting system of Fig. 1;
Fig. 3 is a fragmentary elevational view in cross section showing in enlargement a portion of a structure shown in Fig. 2;
Fig. 4 is a fragmentary elevational view in cross section showing in enlargement another portion of the structure of Fig. 2;
Fig. 5 is a block diagram showing a control portion of the electric-component mounting system;
Fig. 6 is a fragmentary plan view showing in enlargement a portion of an electric-component mounting system according to another embodiment of this invention;
Fig. 7 is a fragmentary side elevational view (partly in cross section of the electric-component mounting system of Fig. 6;
Fig. 8 is a fragmentary plan view showing in enlargement a portion of an electric-component mounting system according to a further embodiment of this invention; and
Fig. 9 is a side elevational view in cross section schematically showing an image-taking device and the associated components in a still further embodiment of this invention.

### DETAILED DESCRIPTION OF THE PREFERRED EMBODIMENTS

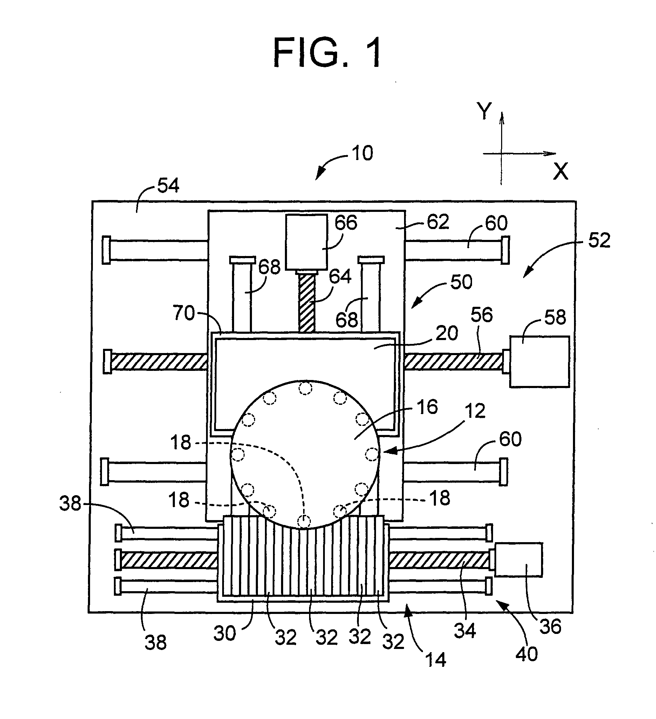

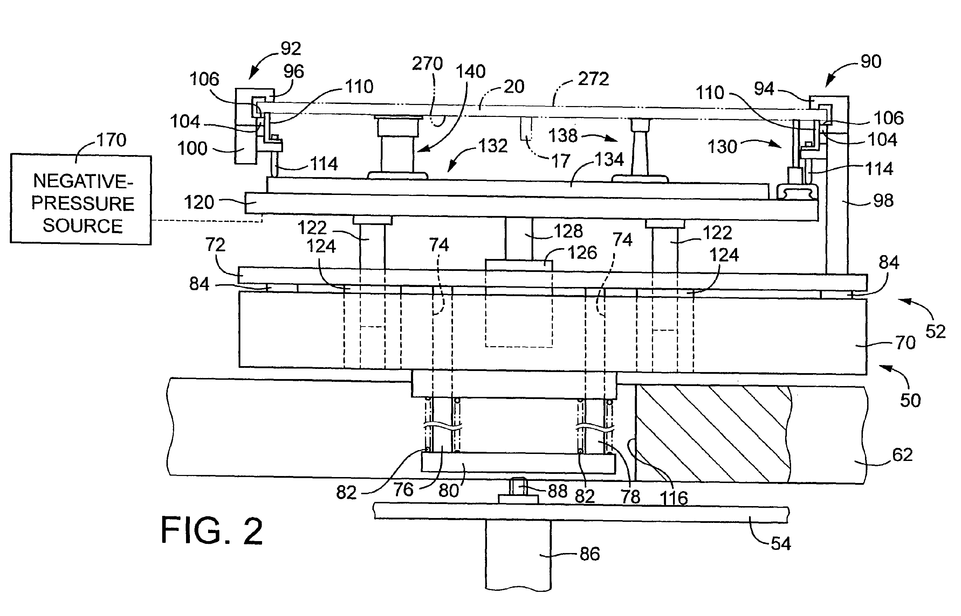

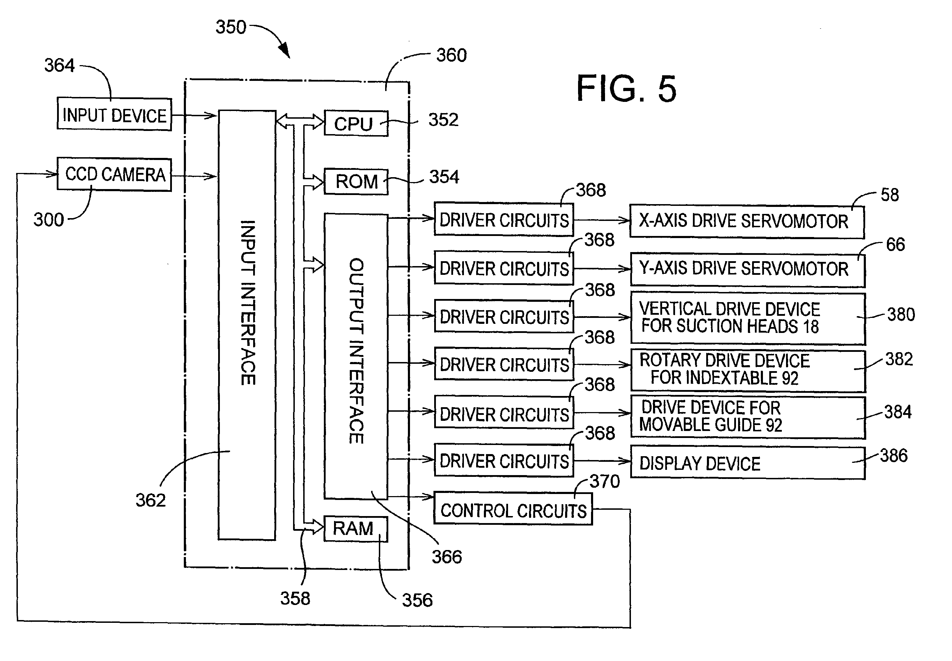

Referring first to Fig. 1, there is shown an electric-component mounting system 10 constructed according to a first embodiment of this invention. The present electric-component mounting system 10 is similar in construction to a system disclosed in co-pending Patent Application Serial Number 09/745,876, except for the position and construction of image-taking devices 140 and the related components, which will be described. The system 10 includes an electric-component mounting device 12 and an electric-component supply device 14. The electric-component mounting device 12 includes an index table 16 which is intermittently rotatable about a vertical axis. The index table 16 carries a plurality of suction heads 18 equiangularly spaced from each other in the circumferential direction. Each of the suction heads 18 is arranged to hold an electric component 17 (Fig. 2) by suction under a negative pressure. The index table 16 is intermittently rotated by an intermittent rotary drive device 382 (Fig. 5) which includes an indexing servomotor, a cam, a cam follower and a rotary shaft. With an intermittent rotary motion of the index table 16, the suction headsl8 on the index table 16 are sequentially brought into different working stations or positions, such as a component-supply position (component receiving position), a component-attitude detecting position, a component-attitude rectifying position, and a component mounting position. Thus, each suction head 18 is successively located at the different working positions during rotation of the index table 16, for eventually performing a working operation on a printed-wiring board 20, when the suction head 18 is located at the component mounting position. In this specific embodiment, each suction head 18 mounts the electric component 17 (which is typically an electronic component) on the printed-wiring board 20. It will be understood that the suction heads 18 function as working heads operable to perform a working operation in the form of a component mounting operation on the printed-wiring board 20. In the present embodiment, electric components are mounted on the opposite surfaces 270, 272 of the printed-wiring board 20. In the example of Fig. 2, electric components will be mounted on the surface 272 of the board 20 after electric components have been mounted on the other surface 270, as indicated at 17 by way of example.

The electric-component supply device 14 includes a feeder support table 30 and a plurality of tape feeders 32 mounted on the feeder support table 30. The tape feeders 32 are arranged in parallel with each other on the feeder support table 30 such that component-supply portions of the tape feeders 32 are located on a straight line in the horizontal plane, which straight line is parallel to an X-axis direction indicated in Fig. 1. The feeder support table 30 is movable in the X-axis direction by rotation of a ballscrew 34 by an X-axis drive servomotor 36, while the table 30 is guided by a pair of guide rails 38. With the movement of the table 30 in the X-axis direction, the component-supply portion of a selected one of the tape feeders 32 is located at the component-supply position of the index table 16. The ballscrew 34 and the X-axis drive servomotor 36 constitute a major portion of a table positioning device 40 operable to position the feeder support table 30 in the X-axis direction. In the present embodiment, each tape feeder 32 has a tape cartridge accommodating a carrier tape, and a tape feeding portion operable to feed the carrier tape from the tape cartridge toward the component-supply portion. The carrier tape holds a succession of the electric components accommodated in respective recesses formed therein, and the tape feeding portion is operated to intermittently feed the carrier tape to feed the electric components one after another to the component-supply portion. It will be understood that the tape feeding portion functions as a component feeding portion for feeding the electric components, while the tape cartridge function as a component storage portion for accommodating the electric components.

The printed-wiring board 20 is supported and moved to a desired position in the horizontal plane (XY plane), by a printed-wiring-board positioning and supporting device 52 (hereinafter referred to as "board positioning device 52") which includes an XY positioning table 50. The board positioning device 52 is mounted on a machine base 54, together with the electric-component mounting device 12 and electric-component supply device 14 which have been described above. The board positioning device 52 is adapted to receive the printed-wiring board 20 from an incoming conveyor device (not shown), and transfer the board 30 to an outgoing conveyor device after the electric components 17 have been mounted on the board 20. Each of the incoming and outgoing conveyor devices includes respective belt conveyors for feeding the board 20 in the X-axis direction. The XY positioning table 50 includes an X-axis slide 62, and a Y-axis slide 70. The X-axis slide 62 is linearly moved in the X-axis direction by rotation of a ballscrew 56 by an X-axis drive servomotor 58, while the slide 62 is guided by a pair of guide rails 60. The Y-axis slide 70 is mounted on the X-axis slide 62, and is linearly moved in a Y-axis direction by rotation of a ballscrew 64 by a Y-axis drive servomotor 66, while the slide 70 is guided by a pair of guide rails 68. The servomotors 58, 66 serving as a drive source for the X-axis and Y-axis slides 62, 70 are electric rotary motors whose angles of rotation are controllable with high accuracy. However, the servomotors 58, 66 may be replaced by stepping motors, or linear motors.

As shown in Fig. 2, a first elevator 72 is mounted on the Y-axis slide 70 such that the first elevator 72 is not movable in the X-axis and Y-axis directions relative to the Y-axis slide 70, and is movable in the vertical direction, namely, in a Z-axis direction perpendicular to the X-axis and Y-axis directions. The Y-axis slide 70 has a pair of through-holes 74 formed therethrough in the Z-axis direction, and two rods 76, 78 extend through the respective through-holes 74 such that the two rods 76, 78 are movable in their longitudinal direction relative to the Y-axis slide 70. The first elevator 72 is fixed to the upper ends of the rods 76, 78 that are located above the Y-axis slide 70.

The rods 76, 78 are connected together by a connecting bar 80 at their lower ends located below the Y-axis slide 70. Elastic members in the form of two compression coil springs 82 serving as biasing means are disposed around the lower end portions of the respective rods 76, 78 which extend downward from the Y-axis slide 70. The springs 82 are held at their lower ends in abutting contact with the connecting bar 80, so that the first elevator 72 is normally held at its lowered position under a biasing force of the springs 82. In the lowered position, the first elevator 72 rests on stops 84 provided on the Y-axis slide 70. On the machine base 54, there are also mounted a fluid-actuated cylinder in the form of an air cylinder 86 serving as a drive source for the first elevator 72. An adjusting screw 88, which is fixed to a piston rod of the air cylinder 86, is held in abutting contact with the connecting bar 80. When the air cylinder 86 is activated, the connecting bar 80 is moved upwards by the adjusting screw 88, so that the first elevator 72 is moved to its elevated position which is spaced a suitable distance upward from the Y-axis slide 70.

On the first elevator 72, there are mounted a stationary guide 90 and a movable guide 92. Each of these stationary and movable guides 90, 92 has a generally elongate rectangular shape in cross section, and has a hold-down portion 94, 96 at its upper end. The stationary guide 90 is fixed on a support member 98 in the form of a plate which is fixed on one of opposite end portions of the first elevator 72 which are opposed to each other in the Y-axis direction and which are parallel to the X-axis direction. The support member 98 extends in the X-axis direction so that the stationary guide 90 extends in the X-axis direction. The movable guide 92 is fixed on another support member 100 parallel to the support member 98. The support member 100 is fixed at its opposite longitudinal ends on respective two slides (not shown) which are slidably movable on the first elevator 72 in the Y-axis direction. These two slides are disposed on respective parallel portions of the first elevator 72 which are spaced apart from each other in the X-axis direction and extend in the Y-axis direction. When these slides are moved in the Y-axis direction, the support member 100 and the movable guide 92 both extending in the X-axis direction are moved in the Y-axis direction toward and away from the stationary guide 90. Thus, the distance between the stationary and movable guides 90, 92 can be adjusted depending upon the width dimension of the printed-wiring board 20.

To upper end portions of the inner surfaces of the support members 90, 100 which are opposed to each other, there are fixed respective belt guides 104 such that the belt guides 104 are disposed below the hold-down portions 94, 96 of the stationary and movable guides 90, 92. Two endless conveyor belts 106 are wound on the respective belt guides 104, and are rotated in synchronization with each other by a belt drive device (not shown) which includes a drive source in the form of a belt drive motor. Two presser members 110 in the form of plates are mounted on the respective support members 98, 100 such that the presser members 110 extend in the X-axis direction and are movable in the Z-axis direction. The presser members 110 are located on the inner side of the corresponding conveyor belts 106 which is remote from the support members 98, 100. The presser members 110 are normally held at their lowered position under a biasing action of suitable biasing means (not shown). To the opposite ends of each presser member 110 which are spaced from each other in the X-axis direction, there are fixed two abutment pins 114 such that the two abutment pins 114 extend downward from the corresponding presser member 110.

When the first elevator 72 is located at its lowered position, the first elevator 72 and the printed-wiring board 20 placed on the first elevator 72 are located below the incoming and outgoing conveyor devices, and can be moved with the Y-axis slide 70 in the X-axis and Y-axis directions, without an interference with those conveyor devices. The X-axis slide 116 has an opening 116 formed therethrough so as to extend in the Y-axis direction, so that the lower portions of the two rods 76, 78 extending downward from the Y-axis slide 70 and the connecting bar 80 are permitted to move in the Y-axis direction when the Y-axis slide 70 is moved in the Y-axis direction.

A second elevator 120 is mounted on the first elevator 72 such that the second elevator 120 is vertically movable relative to the first elevator 72. The second elevator 120 has a generally planar shape, and carries a pair of guide members in the form of guide rods 122 attached to its lower surface such that the guide rods 122 axially slidably engage respective guide bushings 124 attached to the lower surface of the first elevator 72. The guide bushings 124 engage respective through-holes formed through the Y-axis slide 70 such that the guide bushings 124 are vertically slidably movable relative to the Y-axis slide 70. A fluid-actuated cylinder in the form of an air cylinder 126 serving as a drive source is attached at a piston rod 128 thereof to the lower surface of the second elevator 120, and at its cylinder housing to the first elevator 72, such that the air cylinder 126 extends in the vertical direction such that the cylinder housing vertically slidably movably engages a hole formed in the Y-axis slide 70.

On the second elevator 120, there are fixed board positioning pins 130 for positioning the printed-wiring board 20 in the horizontal or XY plane.

On the second elevator 120, there is also fixed a board supporting device 132 on which the printed-wiring board 20 is placed. The board supporting device 132 includes a support table 134 on which are fixedly mounted a plurality of backup pins 138. The two image-taking devices 140 indicated above are also mounted on the support table 134 of the board supporting device 132. In Fig. 2, only one backup pin 138 and only one image-taking device 140 are shown, for simplification of illustration. The image-taking devices 140 will be described in detail.

The board supporting device 132 is similar in construction to a device disclosed in co-pending Patent Application Serial Number 09/892,516, except for the provision of the image-taking devices 140. The support table 134 of the board supporting device 132 includes a hold-down plate 150, a base 152, a spacer 154 and a covering plate 156, which are superposed on each other in the order of description. The base 152, which serves as a body of the support table 134, is a relatively thick plate formed of a non-magnetic material such as aluminum. The base 152 has a plurality of vacuum holes 158 formed through its thickness, so as to be open in its upper and lower surfaces. Each of the vacuum holes 158 is a stepped hole including a small-diameter portion having a comparatively small diameter on the side of the spacer 154, and a large-diameter portion having a comparatively large diameter on the side of the hold-down plate 150. The large-diameter portion serves as a valve hole 160. The vacuum holes 158 are located in a zigzag manner.

The spacer 154 is a relatively thin plate having openings formed through its thickness in respective portions thereof corresponding to the vacuum holes 158. The covering plate 156 has also a relatively small thickness, and cooperates with the base 152 to sandwich the spacer 154, so that the openings formed through the spacer 154 are closed at its opposite open ends by the covering plate 156 and the base 152, whereby communication passages 162 corresponding to the openings are formed through the support table 134.

The covering member 156 has a communication hole (not shown) formed through its thickness such that the communication holes communicates with the communication passages 162. The support table 134 is fixed to the second elevator 120 by a suitable fastening device (not shown), such that the communication hole formed through the covering member 156 communicates with a negative-pressure source 170 (Fig. 2) through a communication hole (not shown) formed through the second elevator 120, and a conduit which is connected to the negative-pressure source 170, as indicated by a broken line in Fig. 2. A switch valve (not shown) is provided in the conduit, for selective communication of the communication passages 162 with the negative-pressure source 170 and the atmosphere.

The hold-down plate 150 is a relatively thin plate formed of a ferromagnetic material such as steel and superposed on the upper surface of the base 152. In the present embodiment, the hold-down plate 150 has length and width dimensions substantially the same as those of the base 152 and large enough to cover all of the valve holes 160. The hold-down plate 150, base 152, spacer 154 and covering plate 156 are tightened together into the support table 134, by suitable fastening means such as bolts and nuts, which are located in a peripheral portion of the support table 134 which are located outwardly of the communication passages 162.

The hold-down plate 150 has a plurality of communication holes 180 for each of the valve holes 160. Each communication hole 180 has a circular shape in cross section and a diameter considerably smaller than that of the valve holes 160. The communication holes 180 for each valve hole 160 are arranged along a circle having a center on the center of the valve hole 160, such that the communication holes 180 are equiangularly spaced from each other along the circle.

Each of the base 152, spacer 154 and covering member 156 is formed with a high degree of flatness or straightness of its opposite major surfaces, as disclosed in JP-A-7-15189. The hold-down plate 150 has also a high degree of flatness or straight of its opposite major surfaces, so that the support table 134 has a high degree of flatness or straightness of its upper surface. Since the upper surface of the second elevator 120 on which the board positioning device 134 is exactly parallel to the horizontal plane, the upper surface of the support table 134 removably fixed on the second elevator 120 by suitable fastening means (not shown) is exactly parallel to the horizontal plane.

Each of the vacuum holes 158 is provided with a shut-off valve 200. The valve hole 160 described above has a tapered bottom surface 202 which terminates at the inner end of the small-diameter portion of the vacuum hole 158. The tapered bottom surface 202 is tapered such that its diameter continuously decreases in the downward direction from the upper end of the vacuum hole 158 on the side of the hold-down plate 150 toward the lower end on the side of the spacer 154. The tapered bottom surface 202 provides a valve seat 204 which is covered by a pad 206 formed of a synthetic resin and which faces upwards for contact with a valving member in the form of a ball 208 received within the valve hole 160. In the present embodiment, the ball 208 is formed of a ferromagnetic material such as steel. The hold-down plate 150 has positioning recesses 210 formed in respective portions of its lower surface which correspond to the respective valve holes 160, such that each positioning recess 210 is located within the above-indicted circle along which the communication holes 180 are arranged. Each positioning recess 210 has a part-spherical shape which follows the spherical surface of the ball 208.

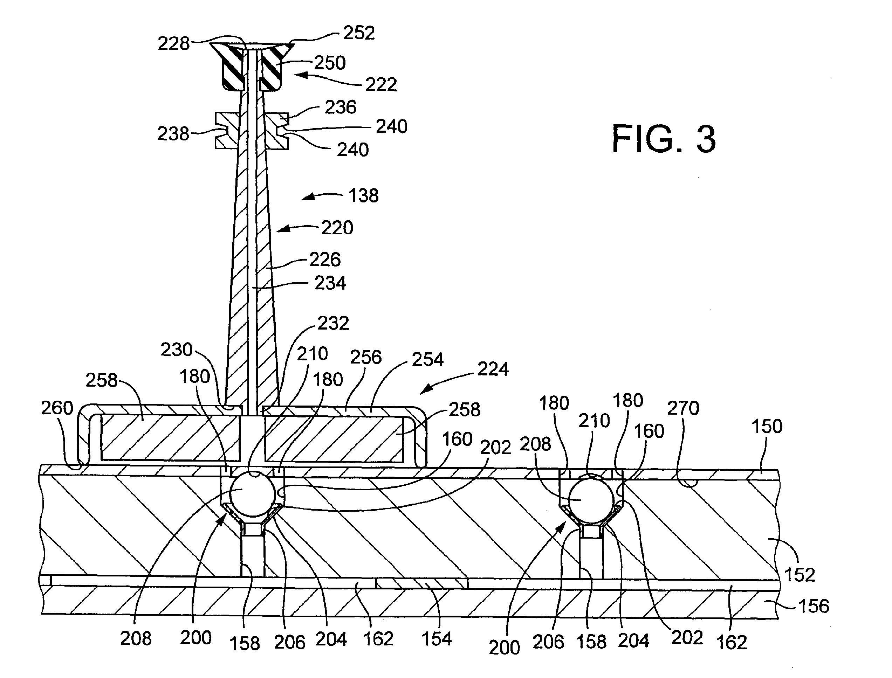

The above-indicated backup pins138 for supporting the printed-wiring board 20 are disposed on the support table 134 constructed as described above. Each of the backup pins 138 has a pin portion 220, a cup portion 222 and a mounting-seat portion 224, as shown in Fig. 3. The pin portion 220 consists of a slightly tapered pin 226 having a circular shape in transverse cross section and a diameter which continuously decreases in the direction from the lower end toward the upper free end. The upper free end of the pin 226 has a flat face 228. The pin 226 has a lower end face 230 which has a central projection 232 having a circular cross sectional shape. The pin 226 has a vacuum passage 234 formed therethrough in its axial direction such that the vacuum passage 234 is open at its opposite ends in the upper end face 228 and the lower end face 230. The pin 226 carries a gripping portion 236 brazed or otherwise fixed to an upper end portion thereof. The gripping portion 236 has a circular shape in cross section and an annular groove 238 formed in an axially intermediate portion of the circumferential surface. The annular groove 238 has a trapezoidal shape in cross section, which is partly defined by a pair of inclined side surfaces 240 that are inclined such that the distance between the surfaces 240 increases in the radially outward direction of the gripping portion 236. The backup pin 138 is gripped at the gripping portion 238 when the backup pin 138 is mounted on the support table 134.

The cup portion 222 has a suction cup 250 removably fitted on the smallest-diameter upper end portion of the pin portion 220 such that the suction cup 250 is not removed from the pin portion 220 during operation of the electric-component mounting system 10. The suction cup 250 is formed of a rubber material, and generally has a diameter larger than that of the upper end face 228. The suction cup 250 has an upper end portion which extends upwards from the upper end face 228 and which has an annular flat end face 252 whose diameter is considerably larger than that of the upper end face 228.

The pin 226 is fixed at its largest-diameter lower end to a mounting seat 254 of the mounting-seat portion 224. The mounting seat 254 is a generally elongate member having a width substantially equal to the largest diameter of the pin 226 and a length which is equal a multiple of the largest diameter. The mounting seat 254 takes the form of a container including a top wall 256 which has an aperture in a longitudinal central portion. The pin 226 is fixed to the top wall 256 by brazing or other suitable fixing means such that the projection 232 is fitted in the aperture and such that the axis of the pin 226 is perpendicular to the plane of the top wall 256. The mounting seat 254 is mounted on the upper surface of the hold-down plate 150, at its open end 260 remote from the bottom wall 256, such that the mounting seat 254 and the upper surface of the hold-down plate 150 cooperate with each other to define a space which communicates with the vacuum passage 234 formed through the pin portion 220. Within this space, there are fixedly accommodated two permanent magnets 258 which are spaced from each other in the longitudinal direction of the mounting seat 254, so as to define a central opening communicating with the vacuum passage 234. Each permanent magnet 258 is a rectangular member having a thickness or height slightly smaller than a depth or height of the mounting seat 254, so that the lower surface of the permanent magnet 258 is spaced a small distance from the end face of the open end 260 in the inward direction of the mounting seat 254.

The board positioning device 132 is further provided with the two image-taking devices 140 described above. The image-taking devices 140 are arranged to take images of fiducial marks (not shown) provided on the back surface 270 of the printed-wiring board 20.

The printed-wiring board 20 has the fiducial marks at respective two or more positions on each of the top and back surfaces 272, 270. Each fiducial mark has a circular shape and a black color. The fiducial marks are preferably provided in at least two of the four corner portions of each surface 270, 272 of the printed-wiring board 20. In the present embodiment, the two fiducial marks are provided in the respective two corner portions of the rectangle of the board 20 which are diagonally opposed to each other. The fiducial marks may have any color providing a sufficiently high contrast with respect to the color of the surfaces 270, 272 of the printed-wiring board 20. The fiducial marks may have any shape other than a circle, for instance, a cross or a triangle.

In the present embodiment, the fiducial marks provided on the front surface 272 and the fiducial marks on the back surface 270 are located at different positions but have a predetermined positional relationship therebetween. Accordingly, the position of the printed wiring pattern on the front surface 272 can be obtained on the basis of the detected positions of the fiducial marks provided on the back surface 270. The fiducial marks on the back and front surfaces 270, 272 are located at the different positions so that the back and front surfaces 270, 272 can be distinguished from each other on the basis of the detected positions of the fiducial marks. If it is not necessary to distinguish the back and front surfaces 270, 272 from each other, the fiducial marks on the back surface 270 and those on the front surface 272 may be located at the same positions.

There will next be described the image-taking device 140s for taking the images of the fiducial marks. The image-taking devices 140 are disposed upright on the support table 134 of the board positioning device 132, so as to take the images of the fiducial marks provided on the back surface 270 of the printed-wiring board 20. While Fig. 2 shows only one of the two image-taking devices 140, for simplification of illustration, the two image-taking devices 140 are disposed at respective positions corresponding to the two fiducial marks.

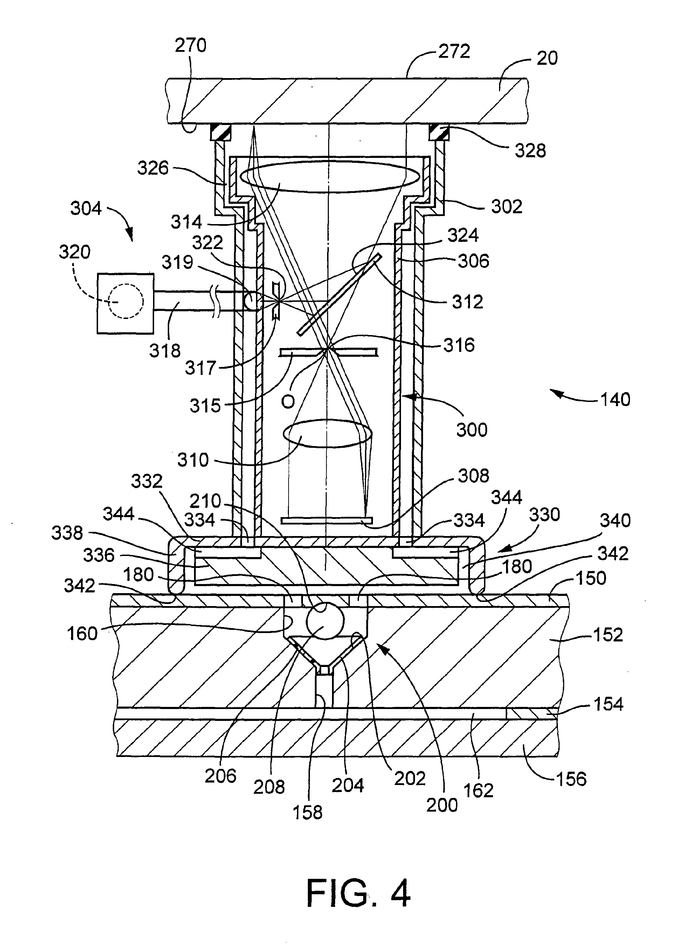

As shown in Fig. 4, the image-taking device 140 includes a CCD camera 300 and a covering member 302, and is connected to an illuminating device 304 located outside the covering member 302. The CCD camera 300, which is similar in construction to a CCD camera as disclosed in JP-A-11-211420, includes a CCD 308, an imaging lens 310, a beam splitter 312, and an objective lens 314, which are disposed coaxially with each other within a stepped cylindrical housing 306. The CCD 308 is a matrix of a multiplicity of small charge-coupled imaging elements which are arranged in a plane and which generate electric signals depending upon optical inputs received from an object. The beam splitter 312 is disposed at an angle of inclination of 45° with respect to the optical axis of the CCD 308. The illuminating device 304 is oriented such that its optical axis extends in the horizontal direction and is inclined 45° with respect to the beam splitter 312. The objective lens 314 and the imaging lens 310 are positioned relative to each other such that the two lens 314, 310 have a common focal point O. An orifice member 315 is disposed at a position corresponding to the common focal point O, and has a small orifice 316 aligned with the focal point O. The illuminating device 304 includes an orifice member 317, a spherical lens 319, an optical fiber 318 and a light source in the form of a halogen lamp 320. A light produced by the halogen lamp 320 is incident upon the spherical lens 319 while being guided by the optical fiber 318, and is condensed by the spherical lens 319 at a small orifice 322 formed through the orifice member 317. The light condensed by the spherical lens 319 is radiated from the orifice 322 toward the beam splitter 312. The imaging lens 310, beam splitter 312, objective lens 314 and spherical lens 319 are positioned relative to each other such that the orifice 322 and the focal point O are plane-symmetrical with each other with respect to a reflecting surface 324 of the beam splitter 312.

The covering member 302 is disposed so as to enclose the entirety of the CCD camera 300. The covering member 302 is a stepped cylindrical member whose inner circumferential surface is spaced by a small clearance from the outer circumferential surface of the CCD camera 300. The covering member 302 is provided at its upper end with a sealing ring 328 for contact with the back surface 270 when the image of the fiducial mark is taken by the CCD camera 300 while the printed-wiring board 20 is held by the board supporting device 132. In other words, the covering member 302 provided with the sealing ring 328 has the same height dimension as the backup pins 138, and cooperates with the backup pins 138 to support the printed-wiring board 20 at the back surface 270. When the printed-wiring board 20 is supported by the image-taking device 140, the covering member 302, printed-wiring board 20 and CCD camera 300 cooperate to define an enclosed annular space 326 which is fluid-tightly isolated from the atmosphere. Since the covering member 302 is colored to prevent transmission of light therethrough, the space 326 is not influenced by an external optical noise when the fiducial mark is imaged by the CCD camera 300.

The CCD camera 300 and the covering member 302 are fixed at their lower ends to a mounting seat 330. The mounting seat 330 is a cup-like member having a larger diameter than the covering member 302, which includes a top wall 332 and has an open end 342 remote from the top wall 332 (CCD camera 300). The CCD camera 300 and the covering member 302 are fluid-tightly fixed by bonding or any other suitable means to the top wall 332 of the mounting seat 330. The top wall 332 of the mounting seat 330 has a plurality of communication holes 334 formed through an annular portion corresponding to the annular space 326 defined between the CCD camera 300 and the covering member 302. The communication holes 334 are spaced from each other along a circle corresponding to the annular space 326. Each of the holes 334 has a diameter smaller than a radial dimension of the annular space 326. Within the cup-like mounting seat 330, there is fixedly accommodated a permanent magnet 336 which has a diameter slightly smaller than the mounting seat 330 and cooperates with a circumferential wall 338 of the mounting seat 330 to define an annular space 340. The permanent magnet 336 has a thickness or height slightly smaller than a depth or height of the mounting seat 330, so that the lower surface of the permanent magnet 336 is spaced a small distance from the end face of the open end 342 in the inward direction of the mounting seat 330. The permanent magnet 336 has a plurality of cutouts 344 formed in its upper surface contacting the top wall 332 of the mounting seat 330, such that the cutouts 344 are held, at their inner ends, in communication with the respective communication holes 334, and extend from the inner ends in the radially outward direction. The cutouts 344 are open at their outer ends to the annular space 340.

The present electric-component mounting system 10 is provided with a control device 350 illustrated in Fig. 5. The control device 350 is constituted principally by a computer 360 including a CPU 352, a ROM 354, a RAM 356, and a bus 358 interconnecting those devices 352, 454, 456. The computer 360 further includes an input interface 362 and an output interface 366 that are connected to the bus 358. To the input interface 362, there are connected an input device 364 and the CCD camera 330. The input device 364 is provided with an operator's control panel and a keyboard. To the output interface 366, there are connected through driver circuits 368 the X-axis drive servomotor 58, the Y-axis drive servomotor 66, a vertical drive device 380 for vertically moving the suction heads 18, the rotary drive device 382 for rotating the index table 16, a drive device 384 for moving the movable guide 92, and a displace device 386. The CCD camera 330 is also connected to the output interface 366 through a control circuit 370. The display device 386 provides various kinds of visible information.

The ROM 354 of the computer 360 stores various control programs such as programs for mounting the electric components 17 on the printed-wiring board 30. The RAM 356 are provided to store groups of information such as the positions of the fiducial marks of the different kinds of printed-wiring board 20 and the mounting positions of the electric components 17.

There will be described an operation of the present electric-component mounting system 10. Before the electric components 17 are mounted on the printed-wiring board 20, the backup pins 138 and the image-taking devices 140 are positioned on the support table 134 of the board supporting device 132, depending upon the specific kind of the board 20 on which the electric components 16 will be mounted. This operation to position the backup pins 138 and the image-taking devices 140 is usually performed manually by the operator of the system 10, but may be automatically performed by the system 10 per se.

When the backup pins 138 and the image-taking devices 140 are positioned on the support table 134, these backup pins 138 and image-taking devices 140 are firmly fixed to the hold-down plate 150 by magnetic forces of the permanent magnets 258 and 336 disposed within the respective mounting seats 254, 330, such that each of the backup pins 138 and the image-taking devices 140 closes any one or ones of the valve holes 160 formed in the support table 134. The balls 208 in the closed valve holes 160 are attracted by the magnetic forces of the permanent magnets 258, 336, so that the corresponding shut-off valves 200 are opened with the balls 208 being spaced apart from the valve seats 204. As a result, the vacuum passages 234 in the backup pins 138 and the annular space 326 and cutouts 344 in the image-taking devices 140 are brought into communication with the communication passages 162 formed through the support table 134. The valve holes 160 are positioned such that distances between the valve holes 160 are smaller than a smaller one of the internal longitudinal dimension of the mounting seat 254 and the inside diameter of the mounting seat 330. Accordingly, the mounting seat 254 or 330 almost always covers at least one of the valve holes 160, irrespective of the position at which each of the backup pins 138 and image-taking devices 140 is mounted on the support table 134, so that the shut-off valve 200 in each closed valve hole 160 is brought to the open state. The phrase "almost always" is interpreted to mean that the mounting seat 254 of a given one of the backup pins 138 or the mounting seat 330 of one of the image-taking devices 140 may be positioned such that a portion of the opening of a given one of the valve holes 160 is located inside the mounting seat 254, 330 while the other portion is located outside the mounting seat 254, 330. In this rare case, the vacuum passage 234 of the backup pin 138 in question or the annular space 326 of the image-taking device 140 in question is not fully communicated with the negative-pressure source 170. Therefore, a care should be taken in positioning the backup pins 138 and the image-taking devices 140, so as to avoid the above-indicated case.

Then, the actual positions of the image-taking devices 140 are detected. Described in detail, an image of one of the suction heads 18 which is located at the predetermined working position is taken by each of the image-taking devices 140. The actual position of each image-taking device 140 is obtained on the basis of the taken image. In the present embodiment, the image of the suction head 18 located at the component mounting position is taken by each image-taking device 14. Described more precisely, the image of the lower end face of the suction nozzle held on the suction head 18 located at the component mounting position is taken. Preferably, the suction head 18 located at the component mounting position holds a suction nozzle which is used exclusively for the purpose of detecting the actual positions of the image-taking devices 14 and which does not have bending or eccentricity. Where the suction nozzle used for mounting the electric components is used, it is desirable to obtain the position of the axis of rotation of the suction nozzle as the position of the suction nozzle. In this case, the position of the axis of rotation of the suction nozzle can be obtained on the basis of two images of the lower end face of the suction nozzle which are taken at two different angular positions of the suction head 18 (e.g., two angular positions having an angular phase difference of 180°).

As indicated above, nominal position data representative of the nominal positions of the image-taking devices 140 are stored in the RAM 356, in relation to the different kinds of the printed-wiring board 20. If each image-taking device 140 is actually located at the nominal position represented by the nominal position data, the position of the image of the suction head 18 taken by the image-taking device 14 corresponds to the nominal position of the image-taking device 14. This position of the image of the suction head 18 need not be aligned with the center of an imaging area of the image-taking device 14. If the position of the image of the suction head 18 taken by the image-taking device 14 deviates from the position corresponding to the nominal position of the image-taking device 14, a distance of this deviation can be used to obtain a distance of this deviation represents a distance of deviation of the actual position of the image-taking device 14 from its nominal position. Thus, the actual position of each image-taking device 14 can be obtained on the basis of the image of the suction head 18.

The positioning of the backup pins 138 and the image-taking devices 14 and the detection of the actual positions of the image-taking devices 14 are required to be effected when the printed-wiring board 20 on which the electric components 17 are to be mounted is changed from one kind to another. The positioning and detection indicated above may be eliminated where the mounting operations are successively performed on the individual printed-wiring boards 20 of the same kind.

The operation to mount the electric components 17 on the printed-wiring board 20 is initiated when the backup pins 138 and the image-taking devices 140 have been positioned on the support table 134 and the actual positions of the image-taking devices 14o have been obtained. Initially, the printed-wiring board 20 is fed from the incoming conveyor device onto the board supporting device 132, by operation of the conveyor belts of the incoming conveyor device and the conveyor belts 106 of the board supporting device 132, while the first elevator 72 and the second elevator 120 are placed at their elevated position and lowered positions, respectively. The printed-wiring board 20 is positioned on the board supporting device 132, by a suitable stopper device (not shown) placed in its operated position. After the rotation of the conveyor belts 106 is stopped, the second elevator 120 is moved upwards with respect to the first elevator 70. During the upward movement of the second elevator 120, the presser members 110 are moved upwards against the biasing force of the biasing means (described above with respect to the presser members 110), with the abutment pins 114 held in abutting contact with the second elevator 120. As a result, the presser members 104 push the printed-wiring board 20 upwards away from the conveyor belts 106. The positioning pins 130 and the board supporting device 132 are moved upwards together with the second elevator 120, so that the positioning pins 130 are inserted at their upper end portions into respective positioning holes formed in the printed-wiring board 20, whereby the board 20 is positioned in the XY plane. Subsequently, the backup pins 138 and the image-taking devices 14 mounted on the support table 134 of the board supporting device 132 are brought into contact at their upper ends with the back surface 270 of the printed-wiring board 20, so that the board 20 is supported on the back surface 270. The upper ends of the backup pins 138 and the image-taking devices 14 contact the back surface 270 of the board 20 when the board 20 has been pressed upwards by the pressure members 110 into contact with the hold-down portions 94, 96 of the stationary and movable guides 90, 92. Then, the switching valve connected to the negative-pressure source 170 is switched to a position in which the communication passages 162 are disconnected from the atmosphere and are connected to the negative-pressure source 170. As a result, the printed-wiring board 20 is held by suction at the back surface 270 by the backup pins 138 and the image-taking devices 14. The board 20 is positioned by the positioning pins 130 in the horizontal plane, and is supported by the backup pins 138 and the image-taking devices 14, with the peripheral portion of the board 20 being supported by and between the hold-down portions 94, 96 and the presser members 110.

After it is confirmed that the printed-wiring board 20 has been supported and positioned on the board supporting device 132, the first elevator 70 is lowered to the lowered position, and the board 20 is moved by the X-axis slide 62 and the Y-axis slide 70, to a first mounting position at which the first electric component 16 is mounted on the board 20. During these movements of the first elevator 72 and the board 20, the image-taking devices 140 are activated to take the images of the fiducial marks provided on the back surface 270 of the board 20. The images of the fiducial marks taken by the image-taking devices 14 are processed to detect a positioning error of the printed-wiring board 20 and compensate the first mounting position for the detected positioning error, before the first electric component 17 has been mounted on the board 20. Described more specifically, the actual position of the board 20 is obtained on the basis of the positions of the images of the fiducial marks and the already obtained actual positions of the image-taking devices 14, and compensation data for compensating the first mounting position are prepared on the basis of the obtained actual position of the board 20, so that the electric component 17 is mounted at the compensated mounting position on the board 20.

When all of the electric components 17 have been mounted on the printed-wiring board 20, the X-axis and Y-axis slides 62, 70 are returned to the home positions at which the printed-wiring board 20 can be transferred from the incoming conveyor device to the board positioning device 52 and from the board positioning device 52 to the outgoing conveyor device. Then, the second elevator 120 is moved to its lowered position to disengage the printed-wiring board 20 from the positioning pins 130, hold-down portions 94, 96, backup pins 138 and the image-taking devices 14. Then, the belt conveyor of the outgoing conveyor device and the conveyor belts 106 of the board positioning device 52 are operated to transfer the board 20 onto the outgoing conveyor device. After or during this unloading operation of the board 20 on which the mounting operation has been completed, the next board 20 on which the electric components 17 will be mounted is transferred onto the board supporting device 52 by the belt conveyor of the incoming conveyor device and the conveyor belts 106 of the board positioning device 52. Thus, one cycle of mounting operation of the present electric-component mounting system 10 is competed.

It will be understood from the foregoing description that the electric-component mounting system 10 constitutes a printed-wiring-board working system arranged to effect a working operation on the printed-wiring board 20, and each of the suction heads 18 serves as a working head for effecting the working operation, and that the X-axis slide 62, the Y-axis slide 70, the X-axis drive servomotor 58 and the Y-axis drive servomotor 66 cooperate to constitute a major portion of a relative-movement device operable to move the printed-wiring board 20 and the suction head 18 at the component mounting position, while the control device 350 serves as a relative-movement compensating portion operable to detect the actual position of the printed-wiring board 20 on the basis of the images taken by the image-taking devices 140, and compensate the relative movement of the board 20 and the suction head 18 on the basis of the detected actual position of the board 20.

In the electric-component mounting system constructed according to the present embodiment of this invention, the actual position of the printed-wiring board 20 is obtained and the mounting position of the electric component 17 on the board 20 is compensated on the basis of the detected actual position of the board 20, while the board 20 is supported by the board supporting device 132, and before the electric component 17 is moved to the mounting position. Accordingly, the working efficiency of the system 10 is significantly improved.

In the present embodiment, the light generated by the halogen lamp 320 is condensed by the spherical lens 319 at a pin hole in the form of the small orifice 322, so that the illuminating device 304 substantially functions as a point light source, enabling the CCD camera 300 to obtain a clear image. On the other hand, the amount of light which passes the orifice 322 is inevitably small, causing the image to be relatively dark. However, the interior of each image-taking device 140 is optically isolated from the outside by the covering member 302 which does not transmit light, so that the image of the fiducial mark can be taken with high quality, without an influence of the external optical noise. However, the use of the point light source is not essential, and a light source having a considerably large area of illumination may be used to increase the amount of light to be incident upon the object.

The covering member 302 of the image-taking devices 140 need not have a cylindrical shape, but may have any other shapes such as a prism. For instance, the upper end portion of each image-taking device 140 which contacts the printed-wiring board 20 may have a rectangular or any other shape, rather than a cylindrical shape. Further, the image-taking devices 140 need not be adapted to support the printed-wiring board 20. Namely, the upper end of the image-taking devices 140 may be spaced a small distance apart from the back surface 270 of the board 20. Where the image-taking devices 140 are adapted to support the board 20 as in the illustrated embodiment, the image-taking devices 140 need not be arranged to hold the board 20 by suction under a negative pressure. The backup pins 138 need not hold the board 20 by suction, either, as in a second embodiment which will be described. The backup pins 138 may be eliminated. In this case, the image-taking devices 140 support the board 20 on the back surface 270.

In the embodiment described above, the actual position of the printed-wiring board 20 is detected on the basis of the images of the two fiducial marks provided on the back surface 270 of the board 20. However, the actual position of the board 20 may be detected on the basis of an image of other indicium such as a selected portion of the printed wiring pattern formed on the back surface 270.

While the electric-component mounting system 10 includes the index table 16 carrying the suction heads 18, the system may use an XY robot which carries component mounting heads and which is movable in the XY plane to move the selected mounting head to a desired mounting position. It is also noted that the principle of this invention of using at least one image-taking device arranged to take an image of an indicium provided on the back surface of a printed-wiring board is equally applicable to any other types of printed-wiring-board working system arranged to effect a working operation of a printed-wiring board, for instance, a screen printing system arranged to effect a screen printing operation on a printed-wiring board, or a printed-wiring-board inspecting system arranged to inspect a printed-wiring board (printed-circuit board) on which the electric components 17 have been mounted.

Where the present invention is embodied as a screen printing system, a screen or stencil and a squeegee cooperate to constitute a working head, and an image provided on the back surface of a printed-wiring board is taken by an image-taking device, and the relative position of the screen and a printed-wiring board is compensated for a positioning error of the printed-wiring board detected on the basis of the image of the indicium taken by the image-taking device.

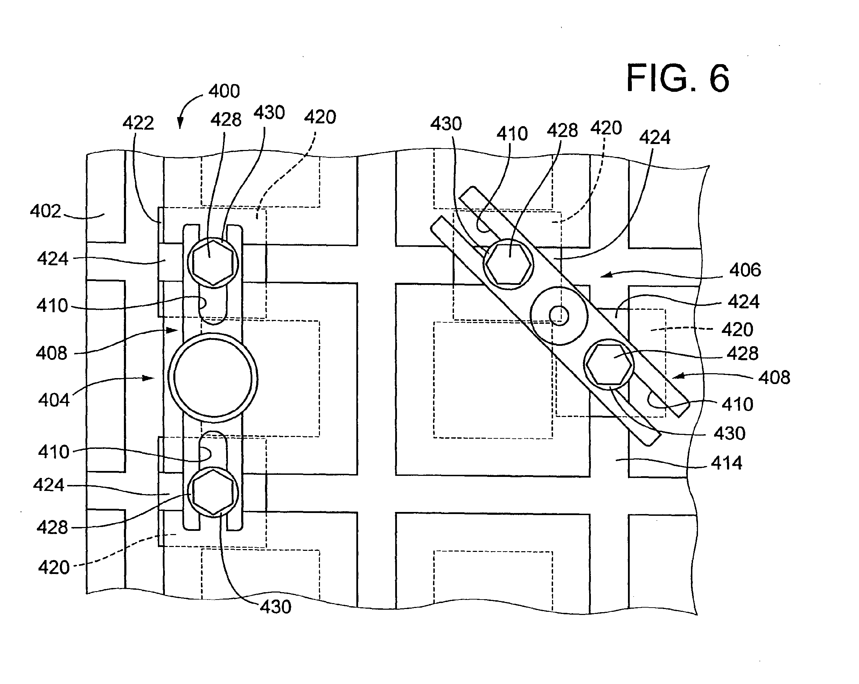

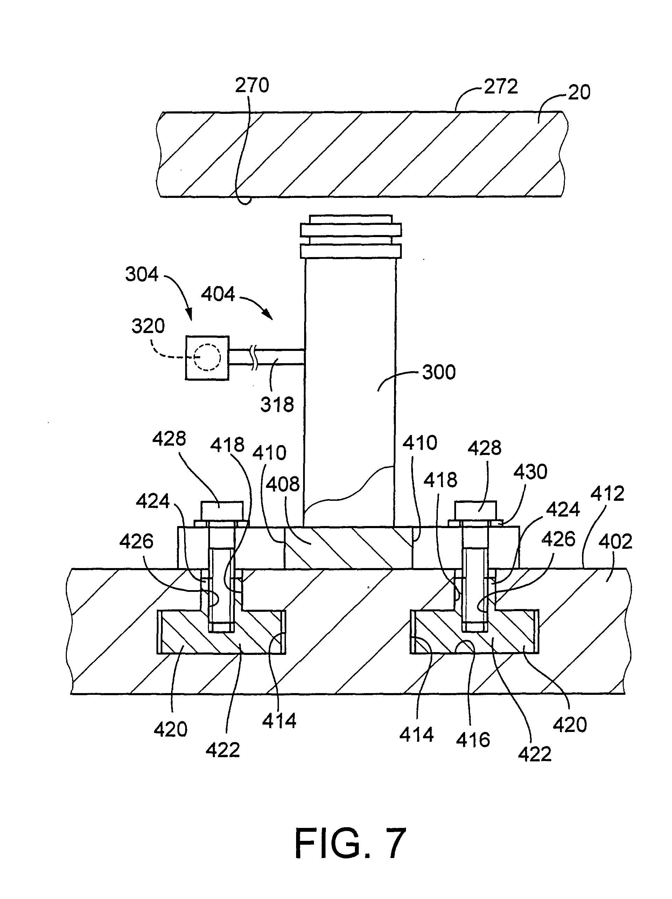

Referring to Figs. 6 and 7, there will be described an electric-component mounting system constructed according to another embodiment of this invention. The electric-component mounting system according to this second embodiment is different from the electric-component mounting system 10 according to the first embodiment, only in the arrangement of a printed-wiring-board supporting device 400 used in the present second embodiment. Only the printed-wiring-board supporting device 400 will be described in detail, and the same reference signs as used in the first embodiment will be used in the second embodiment, to identify the functionally corresponding elements, which will not be described.

The printed-wiring-board supporting device 400 includes a support table 402 on which are fixed two image-taking devices 404 and a plurality of backup pins 406. In Fig. 6, only one of the image-taking devices 404 and only one of the backup pins 406 are shown. The image-taking devices 404 will be discussed first. Each image-taking device 404 includes the same CCD camera 300 as used in the image-taking device 140 in the first embodiment. However, the image-taking device 404 is different from the image-taking device 140, in that the image-taking device 404 does not include a covering member and is not arranged to hold the printed-wiring board 20 by suction under a negative pressure. The device 404 is further different from the device 140, in the arrangement of a mounting seat 408 provided in the second embodiment. The mounting seat 408 will be described.

As shown in Fig. 7, the CCD camera 300 is fixedly disposed on the mounting seat 408. The mounting seat 408 is a generally elongate rectangular plate having two cutouts 410 formed through the opposite longitudinal end portions such that the two cutouts 410 extend from the respective longitudinal end faces of the mounting seat 408 toward a longitudinally central portion. Each cutout 410 has a length which is about one third of the entire length of the mounting seat 408.

The image-taking device 404 including the mounting seat 408 constructed as described above is fixed on the support table 402. The support table 402 has first and second groups of slots 414 formed in an upper surface 414 thereof such that the parallel slots 414 of the first group and the parallel slots 414 of the second group are perpendicular to each other, and cooperate to define a lattice. Each slot 414 has a bottom portion 416 having a relatively large width and an upper portion 418 which is open in the upper surface 412 and which has a relatively small width. That is, each slot 414 is a T-slot having a T shape in cross section, as shown in Fig. 7. A T-block 420 serving as a mounting block is received in each slot 414 such that the Tee block 420 is slidably movable in the slot 414. The T-block 420 has a head portion 422 received in the bottom portion 416 of the slot 414. The head portion 422 has a relatively large width, which is slightly smaller than the width of the bottom portion 416 so that a small clearance is left between the side surfaces of the head portion 422 and the corresponding side surfaces of the bottom portion 416. The head portion 422 has substantially the same thickness as the corresponding dimension of the bottom portion 416, so that the head portion 422 is not movable in the vertical direction within the bottom portion 416. The T-block 420 further has a shank portion 424 which extends upwards from a central part of the bottom portion 416 and which is received in the upper portion 418 of the slot 414. The shank portion 416 has substantially the same width as the upper portion 418. The Tee block 429 has a height dimension which is smaller than the depth of the slot 414, so that the upper end of the shank portion 424 is located below the upper open end of the slot 414. The shank portion 424 has a central threaded hole 426. The mounting seat 408 is bolted to the support table 402 by two bolts 428 which extend through the respective two cutouts 410 and which are screwed into the threaded holes 426 of the two T-blocks 420 in the respective two slots 414 which are located under the respective two cutouts 410. Thus, the image-taking device 404 is fixed on the support table 402. To this end, the mounting seat 408 is positioned so as to intersect the desired two adjacent parallel slots 414 at right angles, and the two T-blocks 420 are positioned in these two slots 414. Accordingly, the image-taking device 404 can be located at a desired position on the support table 402. Since the two cutouts 410 formed in the opposite end portions of the mounting seat 408 have a relatively large length, the bolts 428 can be easily tightened at desired positions along the length of the elongate cutouts 410. In this respect, too, the position of the image-taking device 404 on the support table 402 can be selected with a relatively high degree of freedom. Washers 430 are preferably interposed between the heads of the bolts 428 and the upper surface of the mounting seat 408.

Each of the backup pins 406 is fixed on the support table 402 via a mounting seat which is identical with the mounting seat 408 used for each image-taking device 404. Like the image-taking devices 404, the backup pins 406 can be fixedly disposed at desired positions on the support table 402. Each backup pin 406 does not have the vacuum passage 234 formed in the backup pin 138 in the first embodiment, and does not hold the printed-wiring board by suction.

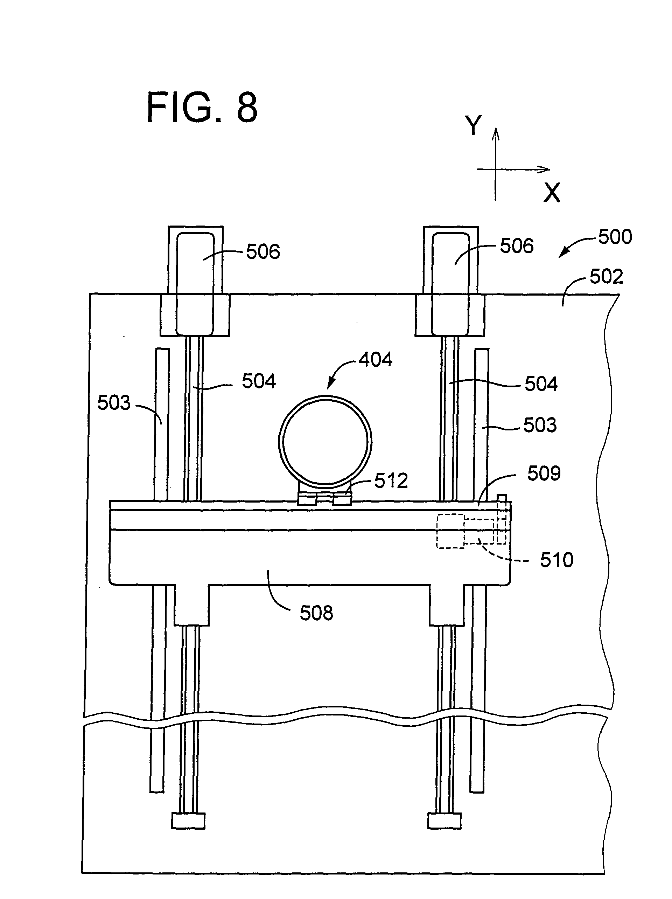

Referring to Fig. 8, there will be described an electric-component mounting system according to a further embodiment of this invention. This system according to the third embodiment is different form the system 10 of the first embodiment, in the arrangement of a printed-wiring-board supporting device 500 used in the third embodiment. Only the printed-wiring-board supporting device 500 will be described.

As shown in Fig. 8, the printed-wiring-board supporting device 500 in the present embodiment includes a support table 502 on which are disposed a pair of guide rails 503 and a pair of ballscrews 504 that extend in the Y-axis direction. The ballscrews 504, which are operatively connected to a Y-axis slide 508, are driven by respective Y-axis drive motors 506, so that the Y-axis slide 508 is moved in the Y-axis direction while being guided by the guide rails 503. On the Y-axis slide 508, there are disposed a pair of guide rails 509 (only one of which is shown in Fig. 8) and a single ballscrew (not shown) which is driven by an X-axis drive motor 510, so that an X-axis slide 512 operatively connected to the ballscrew is moved in the X-axis direction while being guided by the guide rails 509. The Y-axis drive motors 506 and the X-axis drive motor 510, which are provided as drive sources for the Y-axis and X-axis slides 508, 512, are electric motors in the form of servomotors whose amounts of operation can be accurately controlled. In the present embodiment, a single image-taking device 404 is mounted on the X-axis slide 512. The control device 350 controls the two Y-axis drive motors 506 to be operated in synchronization with each other. The control device 350 controls the Y-axis drive motor 506 and the X-axis drive motor 510 according to position data representative of predetermined positions of the image-taking device 404 for each of various kinds of printed-wiring board 20, so that the image-taking device 404 is automatically moved to the predetermined position corresponding to the specific printed-wiring board. The servomotors 506, 510 may be replaced by stepping motors.

In the present third embodiment of Fig. 8, backup pins are disposed on the support table 502, at respective positions selected as desired within an area outside an area of movement of the image-taking devices 404. Each of the backup pins may be fixed to the support table 502 via a mounting structure similar to that provided in the first or second embodiment described above, or any other mounting structure. The backup pins in the present embodiment may support the printed-wiring board while holding it by suction, or may merely support the board on the lower surface.

In the electric-component mounting system according to the third embodiment, the single image-taking device 404 is movable in the X-axis an Y-axis directions, so that two or more fiducial marks provided on the printed-wiring board can be imaged by the image-taking device 404. This movable image-taking device 404 permits accurate detection of the actual position of the printed-wiring board even where the board is formed of a material having relatively low rigidity. The image-taking device 404 is disposed on the support table 502, so as to avoid an interference with the printed-wiring board during movement of the image-taking device 404. Although the present embodiment uses only one image-taking device 404 and the XY positioning device for the device 404, it is possible to provide the system with two ore more movable image-taking devices 404 which are moved by respective positioning devices, each of which may be similar in construction to that shown in Fig. 8. The single image-taking device 404 or each of the image-taking devices 404 may be moved in one of the X-axis and Y-axis directions, or a direction inclined with respect to the X-axis or Y-axis direction. For instance, the single image-taking device 404 may be moved by an appropriate positioning device, along a diagonal line of the rectangular printed-wiring board.

While the X-axis drive ball screw and the Y-axis drive ballscrews 504 are driven by the servomotors 506, 510 in the embodiment of Fig. 8, those ball screws may be rotated by handwheels by the operator of the system, to move the X-axis and Y-axis slides 512, 508.

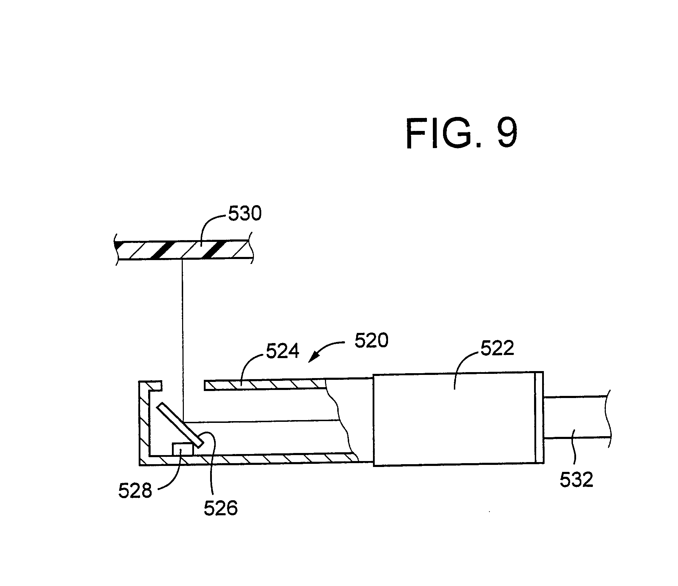

The image-taking device need not be oriented so as to be opposed to an indicium provided on the printed-wiring board. For example, the system may use a horizontally oriented image-taking device 522 provided with a waveguide 520, as shown in Fig. 9. The waveguide 520 includes a housing 524 and a half mirror 526 disposed within the housing 524. The half mirror 526 permits a light emitted from a light emitter 528, to be transmitted therethrough to irradiate a portion of a printed-wiring board 530, while at the same time reflects the light reflected from the board 530, so as to be directed to the image-taking device 522. The light emitter 528 may be a light source, or may be arranged to receive a light from a separate light source through an optical fiber or any other waveguide, and emit the received light toward the printed-wiring board 530. In the present embodiment, the image-taking device 522 has a comparatively small height dimension owing to the horizontal orientation, so that the image-taking device 522 can be easily disposed in a relatively small space provided below the printed-wiring board 530. Although the waveguide device 520 and the image-taking device 522 may be stationary, they are preferably arranged to be movable in the XY plane. In the latter case, the waveguide device 520 and the image-taking device 520 may be moved by a positioning device which is independent of the board supporting device. In the embodiment of Fig. 9, an assembly of the image-taking device 522 and the waveguide device 520 is attached to the free end of an arm 532, which is supported at the fixed end by a suitable arm positioning device such that the arm 532 extends in the horizontal direction. Where the above-indicated assembly is located outside the board supporting device in the horizontal plane, the arm 532 is moved by the arm positioning device in a direction perpendicular to the direction of extension of the arm 532. Where the assembly is located within the board supporting device, the arm 532 is moved in its direction of extension, so as to avoid an interference of the waveguide device 520, image-taking device 522 and arm 532 with the backup pins of the board supporting device.

While the presently preferred embodiments of the present invention have been described in detail, for illustrative purpose only, it is to be understood that the present invention may be embodied with various changes and improvements, such as those described in the SUMMARY OF THE INVENTION, which may occur to those skilled in the art.

Each feature disclosed in this specification (which term includes the claims) and/or shown in the drawings may be incorporated in the invention independently of other disclosed and/or illustrated features.

Statements in this specification of the "objects of the invention" relate to preferred embodiments of the invention, but not necessarily to all embodiments of the invention falling within the claims.

The description of the invention with reference to the drawings is by way of example only.

The text of the abstract filed herewith is repeated here as part of the specification.

A method of detecting a position of a printed-wiring board (20) as held by a board supporting device (132; 400; 500) in a printed-wiring-board working system arranged to effect a working operation on a front surface (272) of the printed-wiring board, wherein at least one image-taking device (140; 404; 522) is operated to take an image of each of at last one indicium provided on a back surface (270) of the board as held by the board supporting device (132; 400; 500), and the position of the board is detected on the basis of a position of the image of each indicium in an imaging area of the image-taking device. Also disclosed are method and system for effecting a working operation on the board, using the detected position of the board.

## Claims

1. A method of detecting a position of a printed-wiring board (20) as held by a board supporting device (132; 400; 500) in a system arranged to operate on a front surface (272) of said printed-wiring board, said method comprising the steps of:
operating at least one image-taking device (140; 404; 522) to take an image of each of at least one indicium provided on a back surface (270) of said printed-wiring board (20) as held by said board supporting device (132; 400; 500); and
detecting the position of said printed-wiring board on the basis of a position of said image of each of said at least one indicium in an imaging area of the corresponding one of said at least one image-taking device.

2. A method according to claim 1, wherein said at least one indicium consists of at least one fiducial mark positioned on said back surface (270) of said printed-wiring board, in a predetermined positional relationship with a printed wiring pattern formed on said front surface (272) of said board.

3. A method according to claim 1, wherein said at least one indicium consists of at least one predetermined portion of a printed wiring pattern which is formed on said back surface (270) of said printed-wiring board, in a predetermined positional relationship with a printed wiring pattern formed on said front surface (272) of said board.

4. A method according to any one of claims 1-3, wherein said printed-wiring board has a plurality of indicia,

5. A method according to claim 4, wherein said at least one image-taking device consists of a plurality of image-taking devices (140; 404), the method further comprising locating said plurality of image-taking devices at respective positions at which the images of said plurality of indicia can be respectively taken by said plurality of image-taking devices.

6. A method according to claim 5, wherein said image-taking devices are located at said respective positions before said printed-wiring board is held by said board supporting device.

7. A method according to any one of claims 5 to 6 wherein said plurality of image-taking devices are manually located at said respective positions.

8. A method of performing aworking operation on a front surface (272) of a printed-wiring board (20) in a system which comprises a board supporting device (132: 400; 500) operable to hold said printed-wiring board, a working head (18) operable to perform said working operation on said front surface of said printed-wiring board, and a relative-movement device (58, 62, 66, 70) operable to move said printed-wiring board and said working head relative to each other in a plane substantially parallel to said front surface, said method comprising the steps of:
operating at least one image-taking device (140; 404; 522) to take an image of each of at least one indicium provided on a back surface (270) of said printed-wiring board (20) as held by said board supporting device (132: 400; 500);
detecting a positioning error of said printed-wiring board as held by said board supporting device, on the basis of a position of said image of said each indicium in an imaging area of the corresponding one of said at least one image-taking device; and
compensating a relative movement between said board supporting device and said working head by said relative-movement device, on the basis of the detected positioning error.

9. A system for performing a working operation on a front surface (272) of a printed-wiring board (20), comprising:
a board supporting device (132: 400; 500) for holding said printed-wiring board:
a working head (18) for performing said working operation on said front surface of said printed-wiring board;
a relative-movement device (58, 62, 66, 70) for moving
said printed-wiring board and said working head relative to each other in a plane parallel to said front surface;
at least one image-taking device (140; 404; 522) for taking an image of each of at least one indicia provided on a back surface (270) of said printed-wiring board (20) as held by said board supporting device (132: 400; 500); and
a control device (350) for controlling said working head, said relative-movement device and said at least one image-taking device, detecting a positioning error of said printed-wiring board as held by said board supporting device, on the basis of a position of said image of said each indicium in an imaging area of the corresponding one of said at least one image-taking device, and compensating a relative movement between said board supporting device and said working head by said relative-movement device, so as to reduce said detected positioning error.

10. A system according to claim 9, further comprising an imaging-device holding device (134, 330, 336; 402, 408, 422, 428), disposed so as to be opposed to said back surface (270) of said printed-wiring board, for holding said at least one image-taking device (140; 404).

11. A system according to claim 10, wherein said imaging-device holding device includes a mounting device (330, 336; 402, 408, 420, 428) for holding said at least one image-taking device such that a position of each of said at least one image-taking device is adjustable.

12. A system according to claim 11, wherein said imaging-device holding device includes a support table (132) having a substantially flat supporting surface, and said mounting device includes a mounting member (254) to which each of said at least one image-taking device (140) is fixed, one of said support table and said mounting member including a magnetic portion (336), while the other of said support table and said mounting member including a ferromagnetic portion (150) formed of a ferromagnetic material.

13. A system according to claim 11, wherein said imaging-device holding device has a substantially flat supporting surface and a first and a second group of T-slots (414), said first group of T-slots consisting of a plurality of parallel T-slots, and said second group of T-slots consisting of a plurality of parallel T-slots perpendicular to the T-slots of said first group, and wherein said mounting device includes a plurality of T-blocks (420) slidably received in said T-slots (414), and fastening members (408, 428) which cooperate with said T-blocks to hold said at least one image-taking device (404).

14. A system according to claim 9, further comprising an imaging-device holding device (506, 508, 510, 512; 532), movable in two mutually perpendicular directions, for holding said at least one image-taking device (404; 522)

15. A system according to claim 14, wherein said imaging-device holding device includes two movable members (508, 512), and an X-axis drive device (509, 510) and a Y-axis drive device (506, 503, 504) which include respective drive sources (510, 506) operable to move said two movable members in an X-axis direction and a Y-axis direction, respectively, and a controller (350) for controlling said drive sources.

16. A system according to any one of claims 9-15, further comprising a moving device (72, 86, 120, 126) for moving said imaging-device holding device (134, 330, 336) toward and away from said back surface (270) of said printed-wiring board held by said board supporting device (132).

17. A system according to any one of claims 9-15, wherein each of said at least one image-taking device (140) includes a contact portion (328) for contact with said back surface (270) of said printed-wiring board, to support said printed-wiring board on said back surface.

18. A system according to claim 17, wherein said contact portion has a contact surface shaped to enclose one of said at least one indicium such that said contact surface is located outwardly of said one indicium.

19. A system according to any one of claims 9-18, wherein said at least one image-taking device consists of a plurality of image-taking devices (140; 404).

20. A system according to any one of claims 9-19, wherein said working head is an electric-component mounting head (18) operable to mount an electric component (17) at a predetermined position on said front surface (272) of said printed-wiring board (20).
